# EUROPEAN PATENT APPLICATION

(11) **EP 4 395 481 A1**
(43) Date of publication of application: **03.07.2024**
(21) Application number: 23216862.5
(22) Date of filing: 14.12.2023
(51) Int. Cl.: H05K 5/02

(54) **CONTROL APPARATUS**

(30) Priority: 27.12.2022 JP 2022210161
(71) Applicant: Brother Kogyo Kabushiki Kaisha, Nagoya, Aichi 467-8561 (JP)
(72) Inventor: KUMAGAI, Yosuke, Nagoya, 467-8562 (JP)
(74) Representative: Prüfer & Partner mbB Patentanwälte · Rechtsanwälte

(57) **Abstract**

A control apparatus 10 includes an outer housing 30, an inner housing 40, a panel 20, and an engaging mechanism 60 configured to engage the panel 20 to the inner housing 40. The engaging mechanism 60 includes a hook 61, a bush 63, a washer 65 and a pin 67. A tube portion 63A of the bush 63 has a length larger than a thickness of a second extending portion 61C, of the hook 61, extending in a direction intersecting a drawing direction of the inner housing 40. A collar portion 63B of the bush 63 has an outside diameter larger than an outside diameter of a tube portion 63A of the bush 63. The washer 65 has an inside diameter larger than an outside diameter of the tube portion 63A. A head 67B of the pin 67 has an outside diameter larger than an inside diameter of the through-hole 63C of the bush 63.

## Description

### BACKGROUND

The following disclosure relates to a control apparatus configured to control an external device.

Patent Document 1 (Japanese Patent Application Publication No. 2-88844) discloses a position adjusting device capable of fixing a decorative face panel in which the position adjusting device prevents the decorative face panel from moving in a height direction (in a Z direction) while the position adjusting device has a clearance allowing the decorative face panel to move in a horizontal direction (in a X direction) and in a vertical direction (in a Y direction).

There has been known a control apparatus configured to control an external device and including an outer housing and an inner housing, and the inner housing is configured to be drawable from the outer housing. For example, a panel is fixed to the inner housing, and the panel covers an opening of the outer housing in a state in which the inner housing is accommodated in the outer housing. It is required that the position of the panel is exactly identical with the position of the opening of the outer housing from the viewpoint of a design and a sealing structure achieving dustproof and waterproof performance, however, there is a difference between the position of the panel and the position of the opening of the outer housing due to factors such as assembly accuracy, a play and a warp. It is preferable to comprise a structure capable of adjusting the position of the panel based on the occurred difference.

### SUMMARY

The position adjusting device of the decorative face panel disclosed in Patent Document 1 is configured to adjust the position of the decorative face panel, however, the position adjusting device has not been applied to a structure in which the inner housing fixed to the panel is drawn, together with the panel, from the outer housing when the panel is pulled. Accordingly, the position adjusting device disclosed in Patent Document 1 cannot solve the specific problem regarding the above described structure. More specifically, in a case where there is a play allowing the panel to move with respect to the inner housing, there is a possibility that the panel tilts so that the panel comes close to or moves away from the inner housing at the connecting portion between the panel and the inner housing when the panel is pulled. In this case, the position adjusting device of the decorative face panel disclosed in Patent Document 1 cannot solve the problem.

The present disclosure provide a technique capable of resolve a problem occurred when a panel is drawn out with a margin allowing the panel to move with respect to an inner housing.

One aspect of the disclosure relates to a control apparatus including an outer housing including an opening formed on one side surface of the outer housing, an inner housing accommodated in the outer housing so as to be drawable from the outer housing through the opening, a panel having a shape capable of covering the opening and drawable from the outer housing together with the inner housing, the panel being disposed in front of the inner housing in a drawing direction, and an engaging mechanism configured to engage the panel to the inner housing so that a relative positional relationship between the panel and the inner housing is adjustable in a direction intersecting the drawing direction. The engaging mechanism includes a hook including a first extending portion extending in a direction directed from the inner housing to the panel and a second extending portion bent from the first extending portion and extending in a direction intersecting the drawing direction, an opening being formed in the second extending portion, a bush including a tube portion having a through-hole and inserted in the opening of the hook and a collar portion formed continued from the tube portion and contactable with a first surface of the second extending portion, the tube portion having a length larger than a thickness of the second extending portion, the collar portion having an outside diameter larger than an outside diameter of the tube portion, a washer disposed on a second surface, opposite to the first surface, of the second extending portion and through which a part of the tube portion is inserted, the washer having an inside diameter larger than the outside diameter of the tube portion, and a pin including a shank passing through the through-hole of the bush, a head formed continued from a first end of the shank and having an outside diameter larger than an inside diameter of the through-hole of the bush, and a fixer formed continued from a second end of the shank and fixed to the panel.

According to the configuration as described above, it is possible to solve the problem occurred when the panel is pulled, while the play allowing the panel to move with respect to the inner housing is ensured.

### BRIEF DESCRIPTION OF THE DRAWINGS

The objects, features, advantages, and technical and industrial significance of the present disclosure will be better understood by reading the following detailed description of the embodiment, when considered in connection with the accompanying drawings, in which:
Fig. 1 is a perspective view illustrating an external appearance of a control apparatus of the present disclosure;
Fig. 2 is a view illustrating a state in which an inner housing of the control apparatus illustrated in in Fig. 1 is drawn out;
Fig. 3 is a partial enlarged perspective cross-sectional view illustrating a surrounding area of an engaging mechanism of the control apparatus illustrated in Fig. 1;
Fig. 4 is a partial enlarged view illustrating taken along line IV - IV in Fig. 3.

### EMBODIMENTS

There will be described below an embodiment of the present disclosure in details with reference to drawings. In the drawings used by the following description, it may be dispensed with to draw a part of a main configuration, and the ratio among the drawn parts and the like are not necessarily accurate. In each of the drawings, a front and rear direction D1, an up and down direction D2 and a right and left direction D3 indicate corresponding directions illustrated in each of the drawings.

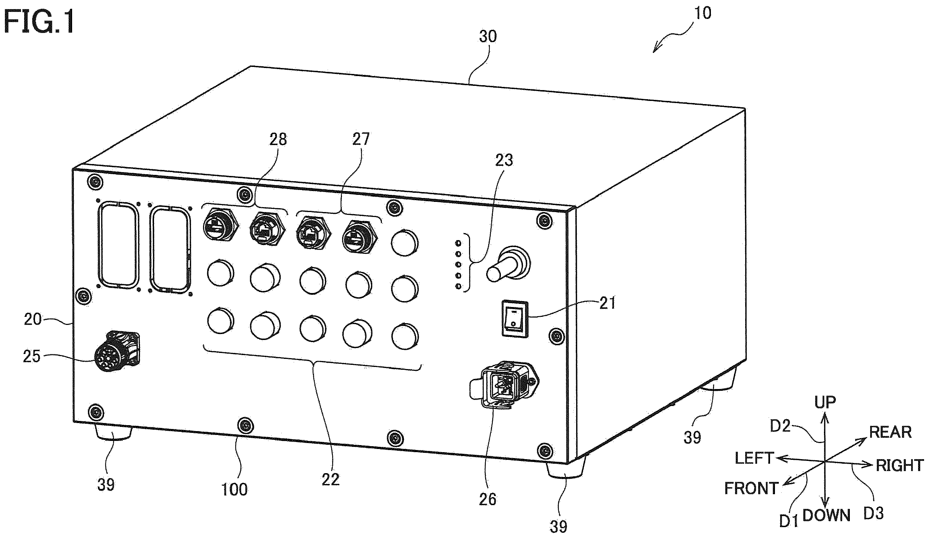

Fig. 1 illustrates an external appearance of a control apparatus 10 of a first embodiment of the present disclosure. The control apparatus 10 controls an external device. In the present embodiment, a laser head as the external device, not illustrated, having a laser emitter is connected to the control apparatus 10. The control apparatus 10 is configured to execute a marking process in which a two-dimensional scanning is performed on a processing surface of an object to be processed by controlling the laser head. The laser head is an example of a laser light outputting device.

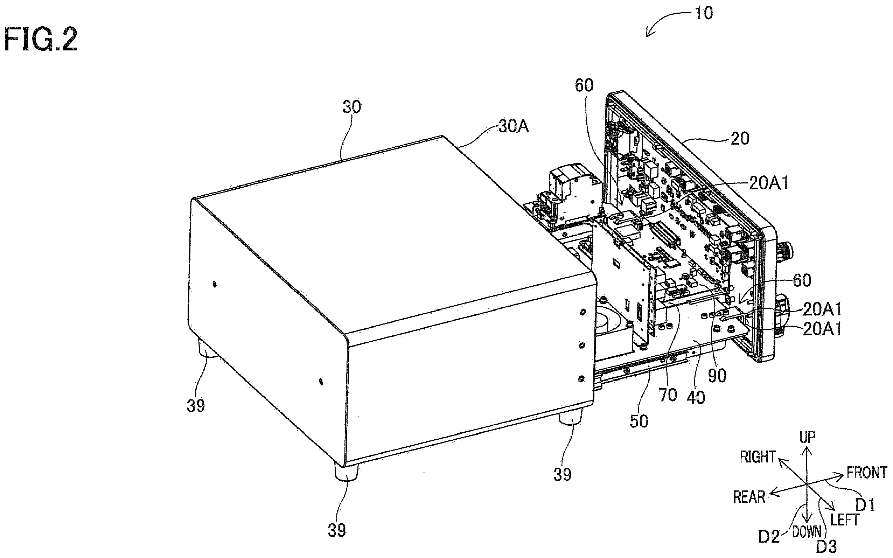

As illustrated in Fig. 1, the control apparatus 10 includes an outer housing 30 which is shaped like a box and has an opening 30A on a front face thereof (see Fig. 2), and a panel 20 configured to cover the opening 30A. And, the panel 20 is screwed and fixed to the outer housing 30 by a plurality of screws 100. On the panel 20, a power switch 21, various kinds of connectors 22, a plurality of indicators 23 consisted of a plurality of LEDs (Light Emitting Diode), a terminal 25 to which a cable, not illustrated, connecting the laser head with the control apparatus 10 is connected, a terminal 26 to which a power cable, not illustrated, for supplying commercial power (for example, 100V) is connected, terminals 27 to which LAN (Local Area Network) cables, not illustrated, are connected, terminals 28 to which USB (Universal Serial Bus) cables, not illustrated, are connected, and the like are provided. That is, the panel 20 has a function of an operational panel. It is noted that four leg portions 39 are provided on an undersurface of the outer housing 30, for example, at four corners of the undersurface, and the four leg portions 39 are in contact with a placement surface of the control apparatus 10.

As illustrated in Fig. 2, the panel 20 is configured so that the panel 20 can be drawn out frontward in a state in which the plurality of screws 100 are removed. An inner housing 40 is connected to a back side of the panel 20, and the inner housing 40 is disposed on a pair of rails 50 including a left-side rail 50 and a right-side rail 50. It is noted that the right-side rail 50 is not illustrated in Fig. 2. Accordingly, when the panel 20 is drawn out frontward, the inner housing 40 is drawn from an inside of the outer housing 30 via the pair of rails 50.

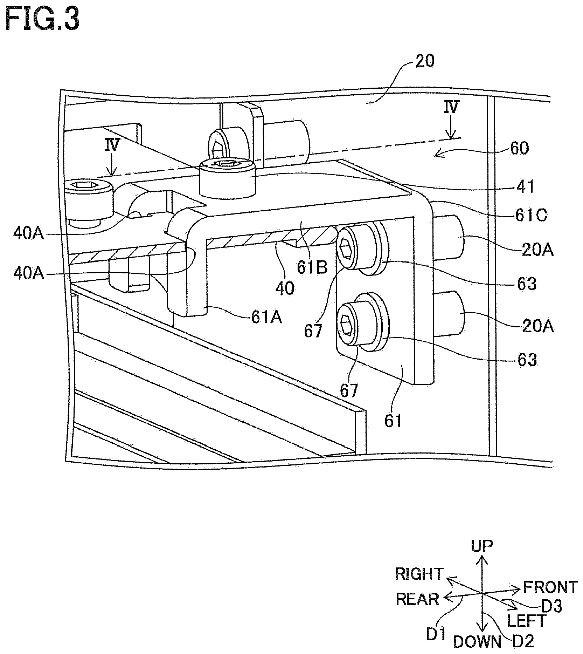

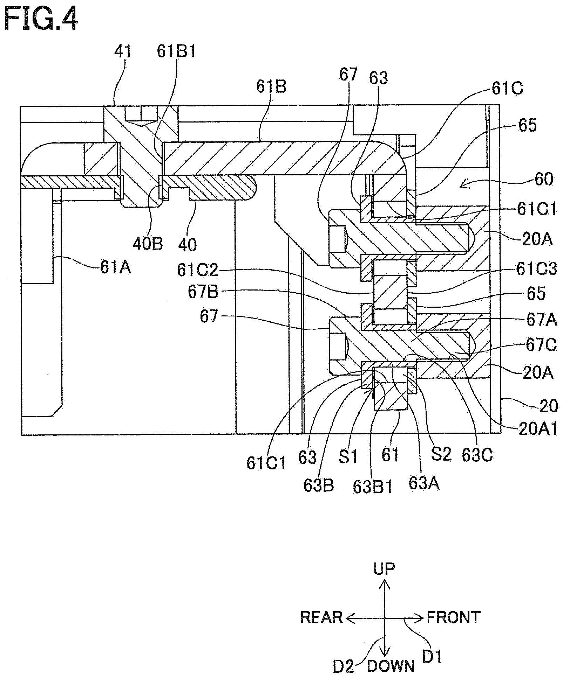

Moreover, a bracket 70 supporting a circuit board 90 on which various kinds of electrical parts are mounted is also fixed to the back side of the panel 20. As described later by referring to Fig. 3 and Fig. 4, the panel 20 is configured so that the panel 20 is relatively movable along a D2-D3 plane with respect to the inner housing 40. Since the bracket 70 is fixed to the panel 20 and the circuit board 90 is fixed to the bracket 70, the circuit board 90 and the bracket 70 relatively moves with respect to the inner housing 40 together with the relative movement of the panel 20 with respect to the inner housing 40. Further, various of kinds of electrical parts are mounted on a surface of the inner housing 40.

The panel 20 and the inner housing 40 are connected to each other by a pair of engaging mechanisms 60. Since respective configurations of the pair of engaging mechanisms 60 are the same, there will be described below a configuration and an effect of one of the pair of engaging mechanisms 60, for example, the left-side engaging mechanism 60, on behalf of the pair of engaging mechanisms 60.

Fig. 3 illustrates a configuration of a surrounding area of the engaging mechanism 60. As illustrated in Fig. 3, the engaging mechanism 60 includes a hook 61, bushes 63, washers 65, see Fig. 4, and screws 67. And, the two bushes 63, the two washers 65 and the two screws 67 are provided.

The hook 61 includes an engaging portion 61A, a connecting portion 61B, as an example of a first extending portion, and a bent portion 61C, as an example of a second extending portion. The engaging portion 61A is consisted of two rod-shaped member bending and extending, in the up and down direction D2 intersecting the front and rear direction D1, from an rear end of the connecting portion 61B, for example, extending downward in the front and rear direction D1. The two rod-shaped member of the engaging portion 61A are inserted into two openings 40A, 40A formed in the inner housing 40 so that the hook 61 is engaged with the inner housing 40. The bent portion 61C is consisted of a plate-shaped member bending and extending downward from a front end of the connecting portion 61B, as the same manner of the engaging portion 61A. The connecting portion 61B is consisted of a plane-shaped member along a D1-D3 plane, and the connecting portion 61B connects the engaging portion 61A with the bent portion 61C. Further, a screw hole 61B1 is formed in the connecting portion 61B (see Fig. 4), and when a screw 41 is screwed into a screw hole 40B formed in the inner housing 40 and the screw hole 61B 1, the hook 61 is engaged with the inner housing 40 so as to be fixed to the inner housing 40.

As illustrated in Fig. 4, two openings 61C1, 61C1, arranged in the up and down direction, are formed in the bent portion 61C. Each of the two openings 61C1, 61C1 has a round shape and the same diameter. The two bushes 63 are respectively inserted into the two openings 61C1, 61C1, and each of the two openings 61C1, 61C1 has the diameter larger than an outside diameter of a tube portion 63A of each of the two bushes 63 by an amount of a predetermined margin so that each of the two bushes 63 is movable along the D2-D3 plane. The amount of the predetermined margin is a range, for example, from 0.5mm to 3.0mm, that is, the diameter of each of the two openings 61C, 61C is a diameter, for example, larger than the outside diameter of the tube portion 63A of the bush 63 by the range from 0.5 mm to 3.0mm.

Each of the bushes 63 includes the tube portion 63A and a collar portion 63B continuously formed from the tube portion 63A. An outside diameter of the collar portion 63B is larger than the outside diameter of the tube portion 63A and is larger than a diameter of the opening 61C1. A through hole 63C through which a shank 67A of the screw 67 penetrates is formed in the tube portion 63A. It is noted that a diameter of the through hole 63C is smaller than an outside diameter of a head 67B of the screw 67. Conversely speaking, the outside diameter of the head 67B of the screw 67 is larger than the diameter of the through hole 63C. The reason is that the bush 63 is firmly clamped between the screw 67 of the head 67B and boss portion 20A.

Moreover, the bush 63 having a length of the tube portion 63A which is larger than a value obtained by adding a thickness of the bent portion 61C into a thickness of the washer 65 is used.

The washer 65 having an inside diameter of which larger than the outside diameter of the tube portion 63A of the bush 63 and an outside diameter of which larger than the diameter of the opening 61C1 is used.

The screw 67 is consisted of the shank 67A, the head 67B formed at a first end of the shank 67A and a thread portion 67C formed at a second end of the shank 67A. Each of outside diameters of the shank 67A and the thread portion 67C is smaller than the diameter of the through hole 63C of the tube portion 63A of the bush 63.

The two boss portions 20A,20A are arranged adjacent to each other in the up and down direction and are disposed at each of positions near to both ends in the right and left direction on the back side of the panel 20 (see Fig. 2). It is noted that the lower-side boss portion 20A located at the position near to the right end of the panel 20 is not illustrated in Fig. 2. Each of the portions 20A, 20A extends rearward from the back side of the panel 20. And, screw holes 20A1, 20A1 are formed in the boss portions 20A, 20A so as to extend along the front and rear direction D1.

The tube portion 63A of the bush 63 is inserted into each of the two openings 61C1, 61C1 of the bent portion 61C, and a part of the tube portion 63A protruding frontward from a front face 61C3 of the bent portion 61C is inserted into the washer 65. And, the shank 67A and the thread portion 67C of the screw 67 penetrates through the through hole 63C of the bush 63 so that the thread portion 67C reaches and screws into the hole 20A1 of the boss portion 20A. As a result of this, the bent portion 61C is fixed to the panel 20 and the hook 61 is fixed to the panel 20, thereby engaging and fixing the panel 20 to the inner housing 40 via the hook 61.

In a state in which the screws 67, 67 are screwed into the boss portions 20A, 20A, a clearance S1 is created between a lower face 63B1 of the collar portion 63B of the bush 63 and a rear face 61C2 of the bent portion 61C of the hook 61. The reason is that, as described above, the bush 63 having the length of the tube portion 63A of the bush 63 larger than the value obtained by adding the thickness of the bent portion 61C into the thickness of the washer 65 is used. It is noted that, where L1 represents a length of the clearance S1 in the front and rear direction D1, L1 is preferably larger than 0 mm and smaller than 0.25 mm.

Moreover, a clearance S2 is also created between the tube portion 63A of the bush 63 and the opening 61C1 of the bent portion 61C. That is, the diameter of the opening 61C1 of the bent portion 61C is larger than the outside diameter of the tube portion 63A of the bush 63. The reason is that, as described above, the hook 61 and the bush 63 are formed so that the diameter of each of the two openings 61C1, 61C1 is larger than the outside diameter of the tube portion 63A of the bush 63 by the amount of the predetermined margin. It is noted that, where L2 represents a length of the clearance S2 in the up and down direction D2, since the predetermined margin is, as described above, the range from 0.5 mm to 3.0 mm and the diameter of each of the two openings 61C, 61C is the diameter larger than the outside diameter of the tube portion 63A of the bush 63 by the range from 0.5 mm to 3.0mm, L2 is equal to or larger than 0.5 mm and equal to or smaller than 3.0 mmm.

In accordance with this, the reason the clearance S2 is created is to ease screwing the panel 20 to the outer housing 30 with the margin of the movement of the panel 20 along the D2-D3 plane when the panel 20 having been drawn from the outer housing 30 is pushed and fixed to the outer housing 30 by a plurality of screws. And, the reason the clearance S1 is created is to decrease friction which is produced when the panel 20 is moved along the D2-D3 plane as soon as possible.

However, it is required that the panel 20 does not tilt in a direction in which the panel 20 comes close to the inner housing 40 or the panel 20 moves away from the inner housing 40 while the panel 40 is drawn out. In a case where the panel 20 tilts in the direction in which the panel 40 comes close to or moves away from the inner housing 40, there is a possibility that load is applied to the circuit board 90 which is fixed to the panel 20 via the bracket 70. To solve this problem, an upper limit of the clearance S1 in the front and rear direction D1 is shortened and set to 0.25 mm as described above and the washer 65 having the outside diameter larger than the diameter of the opening 61C1 is disposed between the opening 61C1 of the bent portion 61C and the boss portion 20A. The washer 65 has a function in which the boss portion 20A does not go into the opening 61C1 when the panel 20 is moved along the D2-D3 plane and a function of decreasing a length of a clearance between the front face 61C3 of the bent portion 61C of the hook 61 and the boss portion 20A. Moreover, since the panel 20 is screwed to the inner housing 40 by the two screws 67 penetrating the two openings 61C1, 61C1 arranged in the up and down direction D2 in the bent portion 61C, the panel 20 does not easily tilt in the up and down direction D2. Further, since the two hooks 61, 61 are disposed so as to be arranged adjacent to each other in the right and left direction D1, the panel 20 does not easily tilt in the right and left direction D1.

As described above, the control apparatus 10 in the present embodiment includes (i) the outer housing 30 including the opening 30A formed on the front face thereof, (ii) the inner housing 40 accommodated in the outer housing 30 so as to be drawable from the outer housing 30 through the opening 30A, (iii) the panel 20 having a shape capable of covering the opening 30A, drawable from the outer housing 30 together with the inner housing 40 and disposed on the front face, in front of the inner housing 40, and (iv) the engaging mechanism 60 configured to engage the panel 20 to the inner housing 40 so that a relative positional relationship between the panel 20 and the inner housing 40 is adjustable in a direction intersecting a frontward direction.

And, the engaging mechanism 60 includes (i) the hook 61 including the bent portion 61C extending in the direction directed from the inner housing 40 to the panel 20 and bending so as to extend in a direction intersecting the forward direction and in which the opening 61C1 is formed, (ii) the bush 63 including the tube portion 63A having the through hole 63C, inserted in the opening 61C1 and having the length larger than the thickness of the bent portion 61C of the hook 61, and the collar portion 63B formed continued from the tube portion 63A, having the outside diameter larger than the outside diameter of the tube portion 63A, and contactable with the rear face 61C2 of the bent portion 61C, (iii) the washer 65 disposed on the front face 61C3 opposite to the rear face 61C2 of the bent portion 61C, having the inside diameter larger than the outside diameter of the tube portion 63A and through which the part of the tube portion 63A is inserted, and (iv) the screw 67 including the shank 67A passing through the through hole 63C of the bush 63, the head 67B formed continued from the first end of the shank 67A and having the outside diameter larger than the inside diameter of the through hole 63C and the thread portion 67C formed continued from the second end of the shank 67A and fixed to the panel 20.

As described above, the control apparatus 10 in the present embodiment is configured such that the engaging mechanism 60 includes (i) the hook 61 including the bent portion 61C extending in the direction directed from the inner housing 40 toward the panel 20, bending and extending in the direction intersecting the forward direction, and having the opening 61C1 formed in the bent portion 61C, and (ii) the bush 63 including the tube portion 63A having the through hole 63C, having the length larger than the thickness of the bent portion 61C of the hook 61 and inserted into the opening 61C1, and the collar portion 63B formed continuous from the tube portion 63A, having the outside diameter larger than the outside diameter of the tube portion 63A and contactable with the rear face 61C2 of the bent portion 61C, (iii) the washer 65 disposed on the front face 61C3 opposite to the rear face 61C2 of the bent portion 61C, having the inside diameter larger than the outside diameter of the tube portion 63A and through which the part of the tube portion 63A is inserted and (iv) the screw 67 including the shank 67A passing through the through hole 63C of the bush 63, the head 67B formed continued from the first end of the shank 67A and having the outside diameter larger than the through hole 63C and the thread portion 67C formed continued from the second end of the shank 67A and fixed to the panel 20. As a result of this, it is possible to leave a suitable margin allowing the panel 20 to relatively move with respect to the inner housing 40. Further, the washer 65 can prevent the problem occurred when the panel is pulled, more especially, prevent the panel 20 from tilting in the direction in which the panel 20 comes close to the inner housing 40 or the panel 20 moves away from the inner housing 40.

It is noted that, in the present embodiment, the front face is an example of one side surface. The forward direction is an example of a drawing direction. Each of the up and down direction D2 and the right and left direction D3 is an example of an intersecting direction. The rear face 61C2 is an example of a first surface. The front face 61C3 is an example of a second surface opposite to the first surface. The thread portion 67C is an example of a fixer. The screw 67 is an example of a pin.

Moreover, the hook 61 includes the plurality of the openings 61C1 formed in the bent portion 61C, and the bush 63, the washer 65 and the screw 67 are configured such that, the plurality of bushes 63, the plurality of washers 65 and the plurality of screws 67 are provided corresponding to the plurality of openings 61C1.

As a result of this, it is possible to engage the panel 20 to the inner housing 40 more securely.

Moreover, the opening of the hook 61 has the diameter larger than the outside diameter of the tube portion 63A of the bush 63 by the range from 0.5 mm to 3.0mm.

As a result of this, it is possible to leave the suitable margin allowing the panel 20 to relatively move with respect to the inner housing 40.

Moreover, where d represents the thickness of the bent portion 61C, L represents the length of the tube portion 63A and M represents the thickness of the washer 65, L-M-d is larger than 0 mm and smaller than 0.25 mm.

As a result of this, it is possible to certainly prevent the panel 20 from tilting in the direction in which the panel 20 comes close to the inner housing 40 or the panel 20 moves away from the inner housing 40.

Moreover, the panel 20 includes the circuit board 90 and the bracket 70 supporting the circuit board 90, and positions of the circuit board 90 and the bracket 70 are changed together with a change of a position of the panel 20 by adjusting a relative positional relationship between the panel 20 and the inner housing 40.

As described above, since the tilt, in the direction in which the panel 20 comes close to or moves away from the inner housing 40, occurred when the panel 20 is drawn out is decreased, the circuit board 90 fixed to the panel 20 via the bracket 70 does not tilt in the direction in which the panel 20 comes close to or moves away from the inner housing 40. As a result of this, it is possible to resolve a risk that load is applied to the circuit board 90.

While the embodiment has been described above, it is to be understood that the disclosure is not limited to the details of the illustrated embodiment, but may be embodied with various changes and modifications, which may occur to those skilled in the art, without departing from the spirit and scope of the disclosure.

The laser head is used as the external device to be controlled in the above described embodiment, however, it is not limited to this.

The LEDs are used as the plurality of indicators 23 in the above described embodiment, however, there are not limited to these. For example, a LED display device may be used, and characters and figures may be displayed on the LED display device.

The switches, indicators and various kinds of connecting terminals are provided on the panel 20 in the above described embodiment, however, any one of the switches, the indicators and the various kinds of connecting terminals may be omitted, and the panel 20 may be configured such that none of the switches, the indicators and the various kinds of connecting terminals are provided.

The two engaging mechanisms 60 are provided in the above described embodiment, however, the number of the engaging mechanisms 60 may be one or equal to or more than three.

The two openings 61C1 are formed in the bent portion 61C of the hook 61 in the above described embodiment, however, the number of the openings 61C1 may be one or equal to or more than three. It is needless to say that the number of each of the bushes 63, the washers 65 and the screws 67 needs to be changed in accordance with the number of the openings 61C1.

The shape of the opening 61C1 is the round shape in the above described embodiment, however, it is not limited to this. The shape of the opening 61C1 may be an oval shape or a rectangular shape.

The control apparatus 10 is configured such that the panel 20 and the inner housing 40 are drawn forward from the outer housing 30 in the above described embodiment, however, the control apparatus 10 may be configured such that the panel 20 and the inner housing 40 may be drawn rearward, leftward or rightward.

## Claims

1. A control apparatus (10), comprising:
an outer housing (30) including an opening (30A) formed on one side surface of the outer housing (30);
an inner housing (40) accommodated in the outer housing (30) so as to be drawable from the outer housing (30) through the opening (30A);
a panel (20) having a shape capable of covering the opening (30A) and drawable from the outer housing (30) together with the inner housing (40), the panel (20) being disposed in front of the inner housing (40) in a drawing direction; and
an engaging mechanism (60) configured to engage the panel (20) to the inner housing (40) so that a relative positional relationship between the panel (20) and the inner housing (40) is adjustable in a direction intersecting the drawing direction,
wherein the engaging mechanism (60) includes:
a hook (61) including a first extending portion (61B) extending in a direction directed from the inner housing (40) to the panel (20) and a second extending portion (61C) bent from the first extending portion and extending in a direction intersecting the drawing direction, an opening (61C1) being formed in the second extending portion (61C),
a bush (63) including a tube portion (63A) having a through-hole (63C) and inserted in the opening (61C1) of the hook (61) and a collar portion (63B) formed continued from the tube portion (63A) and contactable with a first surface (61C2) of the second extending portion (61C), the tube portion (63A) having a length larger than a thickness of the second extending portion (61C), the collar portion (63B) having an outside diameter larger than an outside diameter of the tube portion (63A),
a washer (65) disposed on a second surface (61C3), opposite to the first surface (61C2), of the second extending portion (61C) and through which a part of the tube portion (63A) is inserted, the washer (65) having an inside diameter larger than the outside diameter of the tube portion (63A), and
a pin (67) including a shank (67A) passing through the through-hole (63C) of the bush (63), a head (67B) formed continued from a first end of the shank (67A) and having an outside diameter larger than an inside diameter of the through-hole (63C) of the bush (63), and a fixer (67C) formed continued from a second end of the shank (67A) and fixed to the panel (20).

2. The control apparatus (10) according to claim 1,
wherein the hook (61) includes a plurality of openings (61C1) as the opening (61C1) formed in the second extending portion (61C), and
wherein the bush (63), the washer (65) and the pin (67) respectively have a plurality of bushes (63), a plurality of washers (65) and a plurality of pins (67) respectively corresponding to the plurality of openings (61C1).

3. The control apparatus (10) according to claim 2,
wherein the plurality of openings (61C1) are formed so as to be arranged in the direction intersecting the drawing direction.

4. The control apparatus (10) according to claims 1 or 2,
wherein the engaging mechanism (60) includes a plurality of hooks (61), and each hook (61) is arranged in a direction orthogonal to the direction intersecting the drawing direction.

5. The control apparatus (10) according to claims 1 or 2,
wherein the pin (67) is a screw.

6. The control apparatus (10) according to claims 1 or 2,
wherein the opening (61C1) of the hook (61) is larger than the outside diameter of the tube portion (63A).

7. The control apparatus (10) according to claims 1 or 2,
wherein the opening (61C1) of the hook (61) is larger than the outside diameter of the tube portion (63A) by a range from 0.5 to 3.0mm.

8. The control apparatus (10) according to claims 1 or 2,
wherein the length of the tube portion (63A) of the bush (63) is larger than a value obtained by adding the thickness of the second extending portion (61C) into a thickness of the washer (65).

9. The control apparatus (10) according to claims 1 or 2,
wherein, where d represents the thickness of the second extending portion (61C), L represents a length of the tube portion (63A), and M represents a thickness of the washer (65), L - M - d is larger than 0mm and smaller than 0.25mm.

10. The control apparatus (10) according to claims 1 or 2,
wherein the outside diameter of the collar portion (63B) is larger than a diameter of the opening (61C1) of the hook (61).

11. The control apparatus (10) according to claims 1 or 2,
wherein the panel (20) is an operational panel (20) having a switch (21) and an indicator (23).

12. The control apparatus (10) according to claims 1 or 2,
wherein the panel (20) includes a terminal (25; 26; 27; 28) to which an external device is connected.

13. The control apparatus (10) according to claim 12,
wherein the terminal (25, 26, 27, 28) is connected to a laser light outputting device having a laser emitter, as the external device.

14. The control apparatus (10) according to claims 1 or 2,
wherein the panel (20) includes a circuit board (90) and a bracket (70) supporting the circuit board (90), and
wherein positions of the circuit board (90) and the bracket (70) are changed together with a change of a position of the panel (20) by adjusting the relative positional relationship between the panel (20) and the inner housing (40).
